# EUROPEAN PATENT SPECIFICATION

(11) **EP 2 229 771 B1**
(45) Date of publication and mention of the grant of the patent: **08.06.2011**
(21) Application number: 08859160.7
(22) Date of filing: 07.11.2008
(51) Int. Cl.: H04N 5/44, H03J 1/00

(54) **A BROADCAST RECEIVING DEVICE**
AUSSTRAHLUNGSEMPFANGSEINRICHTUNG
DISPOSITIF DE RÉCEPTION DE DIFFUSION

(30) Priority: 10.12.2007 TR 200708537
(43) Date of publication of application: 22.09.2010
(73) Proprietor: Arçelik Anonim Sirketi, 34950 Istanbul (TR)
(72) Inventor: YASLAN, Hasan, Samet, 34950 Istanbul (TR)
(86) International application number: PCT/IB2008/054671
(87) International publication number: WO 2009/074904

(56) References cited:
- EP-A- 1 511 301
- US-A- 5 020 139
- US-A- 5 317 403
- US-A- 5 483 685

## Description

The present invention relates to a broadcast receiving device controlled by means of a remote control.

Usually a remote control is used when switching channels in broadcasting devices, for example in devices like televisions and satellite receivers. When a key is depressed which is used to specify the channel numbers in a remote control, the broadcast receiving device does not accept the number indicated by the depressed key as the channel number, but waits for another key to be depressed for a certain period of time. If no other key is depressed within the said period of time, at the end of this period, the broadcast receiving device accepts the number indicated by the key depressed initially as the channel number. If another key is depressed within the said period of time, it is again waited for a certain period of time and at the end of the said period, the number indicated by the depressed keys is accepted as the channel number.

The USA patent document No. US5020139, an application within the state of the art, discloses a channel number entry system for entering three digit numbers in a television receiver without depressing an extra key. In the said method, if the time interval during which the first key is being depressed exceeds 2 seconds, then it is detected in the television receiver that a three digit channel number will be depressed. With the said invention, the television receiver is enabled to recognize the three digit channels with the method of a prolonged depression of the key.

In the USA patent document No. US2006181429, another application within the state of the art, each key on the remote control is assigned plurality of functions to enable them to perform plurality of functions. In order for the said different function assigned to the same key to be performed, the key of the remote control is either double clicked or it is depressed for a longer period of time (prolonged depression).

The US patent documents US5317403 and US5483685 both disclose a particular way to enter a channel number, including a plurality of digits, via a remote controller into a television receiver without depressing an extra key. The method of US5317403 allows to enter channel numbers up to two digits. If the first digit is pressed for more than three seconds, it is taken as the channel number. If the first key is released within said period, the two-digit mode is entered and the system waits for the second digit of the channel number to be entered. The method mentioned in US5483685, on the other hand, allows for a plurality of digits to be entered as a channel number. After a digit is entered, the controlled waits a certain predefined time period, sufficient for the user to enter another digit (2,3 seconds). If no digit is entered during said period, the previously entered digits form a channel number to be tuned to.

The objective of the present invention is to realize a broadcast receiving device by which channel tuning is accelerated and facilitated.

In the broadcast receiving device realized to fulfill the objective of the present invention and defined in Claim 1 and in its dependent claims, when the same key is depressed twice rapidly, this is interpreted by the controller as the tuning process will continue. In order for the process of depressing the same key twice rapidly to be completed, a t1 period is defined in the controller. If the same key is not depressed twice within t1 period, the channel assigned to the first depressed key is turned on.

When a key on the remote control is depressed two times rapidly (within t1 period), the controller waits for t2 period for the second digit of the channel number to be entered. t2 period is longer than t1 period and it is long enough to allow entry of the second digit. When a new key is depressed within t2 period two digits are entered, however in order for the controller to select a channel number with two digits, it should be sure that a third digit will not be entered. For this reason, it checks whether or not the key of the number entered as the second digit of the channel number is depressed once more within a short period of time (t1 period). If no channel tuning is performed within the t1 period, the channel assigned to the two digit number is turned on.

After the two digits of the channel number are selected, the controller waits for t1 period to interpret the information of whether or not the third digit will be entered. If the key assigned for the number entered as the second digit of the channel number is depressed once more within t1 period, the controller decides that the third digit will be entered and will wait again for t2 period. If a new key is depressed within this t2 period, a three digit channel number will be entered, but still, for the controller to be able to tune to the channel assigned to the three digit number, it should again wait for t1 period and should check whether or not the key of the number of the third digit is depressed once more. If the key of the number of the third digit is not rapidly depressed once more, the controller will tune to the channel assigned to the three digit number.

In the invention, the period of time allowed for the user to depress the same key two times is the minimum period that will be sufficient for the process. The user requests additional time from the controller by pressing the same key twice. Unless the user requests it, additional time is not granted for the user to switch to the channels with two digit numbers. When tuning to channels with single digit numbers, there is no waiting other than the waiting for the user to request additional time. Additionally, in order to tune to the channels with numbers comprised of a plurality of digits, requesting additional time by the user is repeated after entering each digit. This has reduced total tuning periods for all channel numbers (channels with 1, 2, 3, ... digit numbers).

Furthermore, with the invention, the desired channel with any number can be turned on without depressing any other key than the numbers on the remote control. Thus an ease of use has been provided for the user.

The broadcast receiving device realized to fulfill the objective of the present invention is illustrated in the accompanying figures, in which;

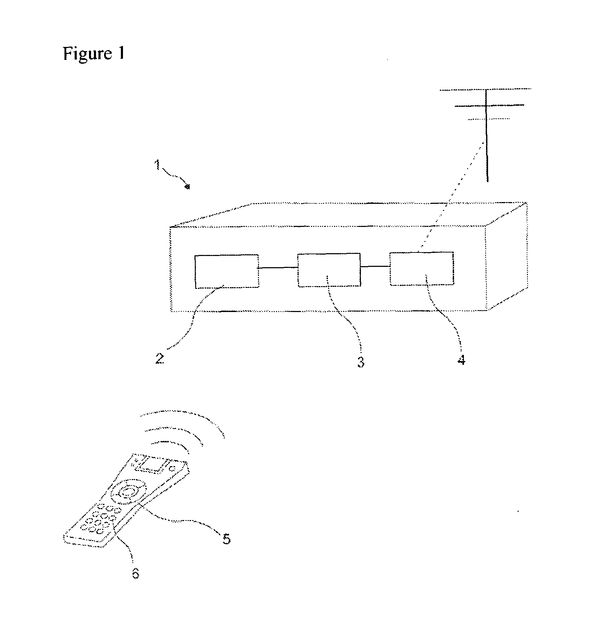

Figure 1 is the schematic view of the inventive broadcast receiving device.

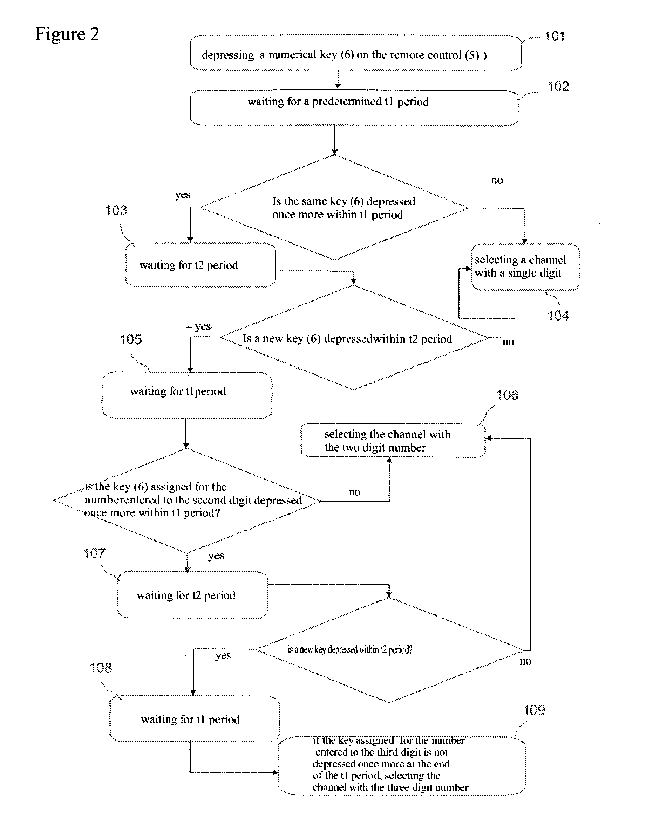

Figure 2 is the flowchart of the control method used in the inventive broadcast receiving device.

The components shown in the figures are numbered as follows:

1. Broadcast receiving device

2. Receiver

3. Controller

4. Tuner

5. Remote control

6. Key

The inventive broadcast receiving device (1) comprises a receiver (2) which detects the signals sent thereto, a controller (3) which determines the process to be carried out according to the signals and a tuner (4) which enables locking to the channel that the controller (3) decides to turn on.

The broadcast receiving device (1) is controlled by a remote control (5). Channel switching signals are sent to the broadcast receiving device (1) via the remote control (5). The remote control (5) comprises keys (6) on which there are numbers from 0 to 9. The keys (6) provided on the remote control (5) are used for selecting the number of the channel that is desired to be watched.

Upon depression of a key (6), the receiver (2) sends the signal that it detects to the controller (3). Which command will be generated by depressing which key (6) for which time interval is defined in the controller (3). If a key (6) is depressed once more within t1 period, this means that tuning process will continue. After a key (6) is depressed on the remote control (5), if the same key (6) is not depressed once more within t1 period, in this case the controller (3) determines the number assigned to the key (6) that is depressed until then as the number of the channel to be selected and enables the tuner (4) to lock to the channel selected. Thus, the channel assigned to a single digit number is turned on.

If a depressed key (6) is depressed once more within t1 period, the controller (3) interprets the situation as that a new key (6) will be depressed and waits for t2 period for a second key (6) to be depressed. If a new key (6) is not depressed within t2 period, the controller (3) determines the number assigned to the key (6) that is first depressed, as the number of the channel to be tuned. If a new key (6) is depressed within t2 period, the controller (3) again waits for t1 period. If the last depressed key (6) is not depressed once more within t1 period, the controller (3) determines the two digit number comprised of the numbers assigned to the two depressed keys (6) as the number of the channel to be selected. Thus, the channel assigned to a two digit number is turned on.

If the last depressed key (6) is depressed once more within t1 period, the controller (3) again waits for t2 period for a new key (6) to be depressed. If a new key (6) is not depressed within t2 period, the two digit number is determined as the number of the channel to be selected. If a new key (6) is depressed within t2 period, the controller (3) again waits for t1 period to check whether or not the last depressed key is depressed once more. If the last depressed key (6) is not depressed once more at the end of the t1 period, it determines the three digit number comprised of the numbers assigned to the three depressed keys (6) as the number of the channel to be selected. Thus the channel assigned to a three digit number is turned on.

The t1 period defined in the controller (3) is long enough to allow the user to depress the same key (6) twice. t2 period is longer than t1 period. t1 and t2 periods are the maximum periods waited for the user to depress a key (6). In case the user depresses a key (6) before the expiration of these periods, it is not waited for the said periods to expire and the signal is immediately interpreted by the controller (3).

In one embodiment of the invention, t1 period is 0.2 and t2 period is 1 second. A user, after depressing a key (6), can depress a second key (6) as fast as in 0.15 seconds.

In the said embodiment, maximum 0.2 seconds is waited after the user depresses a key (6) on the remote control (5) and if the same key (6) is not depressed once more, the channel with a single digit is turned on. Thus the period for a single digit channel to be turned on is 0.2 seconds in total.

In the same embodiment, after a key (6) is depressed, when the same key (6) is depressed once more within 0.15 seconds, although the controller (3) can wait maximum 1 second, a two digit number channel will be coded in 0.30 seconds when the user depresses a new key (6) in 0.15 seconds. However, in order for the controller (3) to select a two digit channel, it should figure out whether or not the third digit will be entered, so it has to wait for a further 0.2 seconds. If a new key is not depressed within 0.2 seconds, the controller (3) selects a channel with a two digit number. Time for turning on a channel with a two digit number is 0.50 seconds in total.

Likewise, in the same embodiment, if a key (6) is depressed on the remote control (5); the depressed key (6) is depressed once more within 0.15 seconds; a new key (6) is depressed within 0.15 seconds; the last depressed key (6) is depressed once more within 0.15 seconds; and a new key (6) is depressed within 0.15 seconds, the controller (3) interprets that a three digit number is entered, however waits for 0.2 seconds to figure out whether or not a fourth digit will be entered. If a new key is not depressed within 0.2 seconds, a channel with a three digit number is allowed to be turned on. Thus, a channel with a three digit number will be turned on within 0.8 seconds in total.

Steps of the control method used in the inventive broadcast receiving device (1) are as follows:

- starting the channel switching process upon depressing a key (6) on the remote control (5) (101)

- waiting for a predetermined t1 period (102)

- if the same key (6) is depressed once more within t1 period, waiting for t2 period to enter the second digit (103)

- if the same key (6) is not depressed once more within t1 period, selecting a channel with a single digit number (104)

- if a new key (6) is depressed within t2 period, waiting for t1 period (105)

- if a new key (6) is not depressed within t2 period, returning to step 104,

- if the key (6) assigned for the number entered to the second digit is not depressed once more within t1 period, selecting the channel with the two digit number (106)

- if the key (6) assigned for the number entered to the second digit is depressed once more within t1 period, waiting for t2 period for the third digit to be entered (107)

- if a new key is not depressed within t2 period, returning to step 106

- if a new key is depressed within t2 period waiting for t1 period (108)

- if the key assigned for the number entered to the third digit is not depressed once more at the end of the t1 period, selecting the channel with the three digit number (109).

In the inventive broadcast receiving device (1), the maximum period of time required for the user to be able to turn on channels with a single digit number is minimized. In the invention, the maximum period of time required to turn on the channels with a single digit number is just enough to allow depressing a single key (6).

The period of time required for the user to turn on the channels with multiple digits is left to the control of the user. That is to say, if the user depresses the same key (6) twice within the minimum period granted to be sufficient to depress one key (6), this will mean that channel selection of the user is not completed and that she/he requests additional time to select a channel. If the user does not inform the controller that she/he requests additional time by depressing the last depressed key within the minimum period granted, the channel number which is selected until that moment is turned on. Thus, unless the user requests it, it is not waited for additional time and the total channel tuning time is minimized.

## Claims

1. A broadcast receiving device (1) comprising a receiver (2) which is controlled via a remote control (5) that enables selection of the number of the channel that is desired to be watched and contains keys (6) including numbers thereon from 0 to 9 and which detects the signals sent by the remote control (5), a controller (3) which determines the process to be carried out according to the signals and at least one tuner (4) which enables locking to the channel selected; **characterized by** a controller (3) which, after depression of a key (6) if the same key (6) is depressed consecutively once more within t1 period, interprets the situation as the tuning process will continue and which, after a key (6) is depressed on the remote control (5) if the same key (6) is not depressed consecutively once more within t1 period, determines the number assigned to the key (6) that is depressed until then, as the number of the channel to be selected.

2. A broadcast receiving device (1) according to Claim 1 **characterized by** a controller (3) which, if a depressed key (6) is depressed consecutively once more within t1 period, waits for t2 period for depression of a new key (6); if a new key (6) is not depressed within t2 period, enables the channel assigned to the first depressed key (6) to be selected; if a new key (6) is depressed within t2 period, waits again for t1 period; if the last depressed key (6) is not depressed consecutively once more within the t1 period, determines the two digit number comprised of the numbers assigned to the two depressed keys (6) as the number of the channel to be selected.

3. A broadcast receiving device (1) according to Claim 2 **characterized by** a controller (3) which, if the last depressed key (6) is depressed consecutively once more within t1 period after the two digits of the number of the channel to be selected are entered, waits again for the new key (6) to be depressed within t2 period; if a new key (6) is not depressed within t2 period, enables selection of the channel assigned to the two digit number; if a new key (6) is depressed within t2 period, waits again for t1 period; if the last depressed key (6) is not depressed consecutively within t1 period, determines the number with three digits comprised of the numbers assigned to the three depressed keys (6) as the number of the channel to be selected.

## Patentansprüche

1. Übertragungsempfangsvorrichtung (1), umfassend einen Empfänger (2), der mittels einer Fernbedienung (5) gesteuert wird, die die Auswahl der Nummer des Kanals ermöglicht, der geschaut werden soll, und die Tasten (6) aufweist, auf denen Ziffern von 0 bis 9 angeordnet sind, und die die von der Fernbedienung (5) gesendeten Signale erkennt, eine Steuerung (3), die entsprechend den Signalen den auszuführenden Prozess bestimmt, und wenigstens einen Kanalwähler (4), der das Festlegen auf den gewählten Kanal ermöglicht; **gekennzeichnet durch** eine Steuerung (3), die nach dem Drücken einer Taste (6) für den Fall, dass dieselbe Taste (6) in Folge ein weiteres Mal innerhalb eines Zeitraums t₁ gedrückt wird, diese Situation als den fortdauernden Kanalauswahlprozess auslegt, und die nach dem Drücken einer Taste (6) auf der Fernbedienung (5) für den Fall, dass dieselbe Taste (6) nicht in Folge ein weiteres Mal innerhalb eines Zeitraums t₁ gedrückt wird, die Ziffer, die der bis dahin gedrückten Taste (6) zugeordnet ist, als die Nummer des auszuwählenden Kanals bestimmt.

2. Übertragungsempfangsvorrichtung (1) nach Anspruch 1, **gekennzeichnet durch** eine Steuerung (3), die für den Fall, dass eine gedrückte Taste (6) in Folge ein weiteres Mal innerhalb des Zeitraums t₁ gedrückt wird, für einen Zeitraum t₂ auf das Drücken einer neuen Taste (6) wartet; die es, wenn innerhalb des Zeitraums t₂ keine neue Taste (6) gedrückt wird, ermöglicht, dass der Kanal, der der ersten gedrückten Taste (6) zugeordnet ist, gewählt wird; die für den Fall, dass innerhalb des Zeitraums t₂ eine neue Taste (6) gedrückt wird, erneut für den Zeitraum t₁ abwartet; und die, falls die zuletzt gedrückte Taste (6) innerhalb des Zeitraums t₁ nicht in Folge ein weiteres Mal gedrückt wird, die zweistellige Zahl, die aus den Ziffern besteht, die den zwei gedrückten Tasten (6) zugeordnet sind, als die Nummer des auszuwählenden Kanals bestimmt.

3. Übertragungsempfangsvorrichtung (1) nach Anspruch 2, **gekennzeichnet durch** eine Steuerung (3), die für den Fall, dass die zuletzt gedrückte Taste (6) innerhalb des Zeitraums t₁ in Folge ein weiteres Mal gedrückt wird, nachdem die zwei Ziffern der Nummer des auszuwählenden Kanals eingegeben wurden, erneut darauf wartet, dass die neue Taste (6) innerhalb des Zeitraums t₂ gedrückt wird; die, wenn keine neue Taste (6) innerhalb des Zeitraums t₂ gedrückt wird, die Auswahl des Kanals ermöglicht, der der zweistelligen Nummer zugeordnet ist; die, falls innerhalb des Zeitraums t₂ eine neue Taste (6) gedrückt wird, erneut für den Zeitraum t₁ wartet; und die, wenn die zuletzt gedrückte Taste (6) nicht in Folge innerhalb des Zeitraums t₁ gedrückt wird, die Nummer mit drei Ziffern, die aus den Ziffern besteht, die den drei gedrückten Tasten (6) zugeordnet sind, als die Nummer des auszuwählenden Kanals bestimmt.

## Revendications

1. Un dispositif récepteur de diffusion (1) comprenant un récepteur (2) qui est contrôlé par une télécommande (5) qui permet la sélection du nombre de la chaîne que l'on veut regarder et contient des touches (6) contenant des numéros là-dessus de 0 à 9 et qui détecte les signaux envoyés par la télécommande (5), un contrôleur (3) qui détermine le processus à effectuer selon les signaux et au moins un tuner (4) qui permet l'accrochage à la chaîne sélectionnée, **caractérisé par** un contrôleur (3) qui, après l'appui sur une touche (6) si la même touche (6) est appuyée consécutivement une fois de plus dans la période t₁, interprète la situation que le processus de réglage se poursuivra et qui, après qu'une touche (6) sur la télécommande (5) est appuyée si la même touche (6) n'est pas appuyée consécutivement une fois de plus dans la période t₁, détermine le chiffre attribué à la touche (6) qui est appuyée jusque là, comme le nombre de la chaîne à sélectionner.

2. Un dispositif récepteur de diffusion (1) selon la Revendication 1, **caractérisé par** un contrôleur (3) qui, si une touche appuyée (6) est appuyée consécutivement une fois de plus dans la période t₁, attend pour la période t₂ l'appui sur une nouvelle touche (6) ; si une nouvelle touche (6) n'est pas appuyée dans la période t₂, permet la sélection de la chaîne attribuée à la première touche appuyée (6) ; si une nouvelle touche (6) est appuyée dans la période t₂, attend encore pour la période t₁ ; si la dernière touche appuyée (6) n'est pas appuyée consécutivement une fois de plus dans la période t₁, détermine le nombre à deux chiffres comprenant les chiffres attribués aux deux touches appuyées (6) comme le nombre de la chaîne à sélectionner.

3. Un dispositif récepteur de diffusion (1) selon la Revendication 2, **caractérisé par** un contrôleur (3) qui, si la dernière touche appuyée (6) est appuyée consécutivement une fois de plus dans la période t₁ après que les deux chiffres du nombre de la chaîne à sélectionner sont entrées, attend encore pour l'appui de la nouvelle touche (6) dans la période t₂; si une nouvelle touche (6) n'est pas appuyée dans la période t₂, permet la sélection de la chaîne attribuée au nombre à deux chiffres ; si une nouvelle touche (6) est appuyée dans la période t₂, attend encore pour la période t₁ ; si la dernière touche appuyée (6) n'est pas appuyée consécutivement dans la période t₁, détermine le nombre à trois chiffres comprenant des chiffres attribués aux trois touches appuyées (6) comme le nombre de la chaîne à sélectionner.
